# EUROPEAN PATENT APPLICATION

(11) **EP 0 912 081 A2**
(43) Date of publication of application: **28.04.1999**
(21) Application number: 98307767.8
(22) Date of filing: 24.09.1998
(51) Int. Cl.: H05K 7/14

(54) **Adaptable case and a modular electronic system**

(30) Priority: 25.09.1997 GB 9720442
(71) Applicant: Roberts Technologies PLC, Bristol BS99 7UD (GB)
(72) Inventor: Roberts, Paul Nicholas, Worle, Weston Super Mare BS22 9EZ (GB)
(74) Representative: Beck, Simon Antony

(57) **Abstract**

A case for a modular electronic system is provided in hold individual modules themselves are encased in their own respective enclosures (30, 32) and these enclosures are then held within a case. Individual modules may then be exchanged or upgraded. A removable panel portion is provided such that the look or controls on the case may be changed or an aperture for loading data carriers may be provided.

## Description

The present invention relates to an adaptable case for a modular electronic system. Such a system provides an easy route to upgrade components within the system without the user requiring a high degree of technical competence.

Many entertainment systems, such as stereo systems or television systems come encased with all the components provided within a single case. This makes it difficult to modify the stereo or television to take advantage of new developments. This problem is particularly easy to recognise in the case of televisions where upgrading a television to accept teletext, nicam stereo sound, cable and satellite, and digital television has required the purchase of expensive and bulky set top boxes or the purchase of a completely new television. This results in many perfectly serviceable components of the original television being discarded. A similar problem now exists in stereo audio systems due to the increasing tendency to provide them as integrated units, although the problem has always existed to some extent, even when stereos were sold as "hi-fi" separates.

The problem of upgrading has been more successfully dealt with by the computer industry, but even there many people shy away from the problems involved in upgrading their Personal Computer since it requires removal of the case to expose the circuit boards of the machine and the introduction of replacement modules and cards into areas carrying many exposed electrical components which can be damaged by the discharge of static electricity. Although there may actually be very little risk in respect of damaging the machine, the fear that they may make a system threatening mistake prevents many people from performing their own upgrades. Additionally a component upgrade may require the addition of a new control panel in order to utilise new features.

According to the present invention, there is provided a case for a modular electronic system wherein the case has a front panel having at least one removable portion such that the removal of the or each portion exposes an aperture for the introduction of data carriers into the enclosure and/or for engaging a removable and/or replaceable control panel.

It is thus possible to provide a case which can be used to house a number of diverse components which may form part of computer, audio and/or video entertainment systems and some of which may require user access thereto, for example cassette transport mechanisms, compact disc transport mechanisms or digital versatile disc mechanisms, in order that a removable data carrier such as an audio cassette, a video cassette, a video disk, a CD or DVD can be introduced to the mechanism. Additionally or alternatively it is possible to change the styling of the case and the user interface by adding, changing or removing a control panel. Thus the control panel can be varied in accordance with the modules contained within the case. The control panel may also contain an aperture for the passage of a removable data carrier.

A case may hold a plurality of modules that are grouped by function to implement a specific device. Thus, taking the example of hi-fi separates, it may be desired to form a compact disc player within a case. Thus the case may enclose a plurality of modules, one of the modules may include the disc transport mechanism, another may include a power supply unit and a further module may include the processing electronics, ie the digital to analogue converter and buffers. This arrangement makes it easy to upgrade the CD player to provide enhanced functionality or to cope with future developments. For example, the transport mechanism may be upgraded to play DVD discs which have a higher density of information storage or to use writeable discs, thereby providing both a CD player and CD recorder. This approach can be extended to many other components, thus a cassette deck may be implemented within a case. The case may include one or more tape transport modules, record electronics modules, playback electronics modules, a power supply module, a display module, for example for VU metering or peak metering, a noise reduction module which may contain one or more of the competing noise reduction systems, such as Dolby B, Dolby C, Dolby S and HX Pro. Furthermore, it will then be possible to upgrade the noise reduction system to cope with future developments without needing to change any of the other components. Similarly a power amplifier may be upgraded to have greater output by changing an output stage module or by having further channels added if required. It can be appreciated that any electronic system which is traditionally sold as a single unit, could be subdivided using this system to allow for an easier upgrade path or easier maintenance in the event that a unit fails.

Advantageously many different functions may be integrated within a single case. Thus a case may hold modules for providing power amp functions, pre-amp functions, tape record and playback functions, radio functions, compact disc functions, television functions, video recorder/player functions or data processing functions. Developments such as digital audio tape and digital video disc may also be included within the module. Similarly parts of a television system may also be provided in such an arrangement, thereby enabling the tube size to be changed without requiring replacement of the rest of the television, or further functions such as a digital television card to be added without requiring the replacement of the pre-existing modules.

Advantageously a central controller communicates with all the modules provided within a case. Advantageously only one central controller is required irrespective of the number of modules provided and irrespective of whether or not they are provided in a single case or in multiple cases arranged in proximity to one another.

The inherent flexibility of such a system does pose some problems for the central controller. The controller needs to know what modules it is to control. It is clear that there are a number of options for achieving this, for example the user may identify the module explicitly to the controller at the time of installing it. Alternatively, the controller may poll the system surrounding it in order to determine what modules are present. In a further alternative arrangement, the controller may transmit its identity at each power up and the modules may be arranged to check that they are operating with a controller which they have already communicated with. Thus, at power up, if a module does not recognise the controller it can then identify itself to the controller in order that the controller can update its record of modules in the system. Advantageously each module has a identity assigned to it by the central controller. This enables identical modules to be included within a system but to be distinguishable from one another for control purposes. This may occur if it is desired to provide two or more cassette decks within a system or if the stereo power amplifier is implemented as two identical mono amplifiers.

Preferably each module carries a plurality of plugs and/or sockets on a predetermined space thereof. Advantageously the interconnections between modules are provided on a rear face of each module. The modules may then be interconnected using cables in the manner known to interconnect hi-fi, video or computer components. A rear panel may be provided to the case for hiding the wiring. Alternatively, a back plane may be provided in which the wiring is already formed. This arrangement is to some extent less flexible than the "spaghetti wiring" approach and would require the possible inclusion of a number of switches on the back plane or a plurality of back planes to be manufactured depending on module layout. As a further alternative, the modules may communicate with one another over a multiplexed bus. The signal and data exchange may be performed in the digital domain and could be implemented relatively inexpensively since these features can be integrated within mass produced integrated circuits. In this arrangement each unit would simply carry one or two plugs depending on whether information and data would be exchanged via the same or separate busses, and optionally a power socket if this is to be provided separately.

The or a case may also house transducer elements. Thus it is possible to provide speakers capable of accepting a plurality of modules therein. It will thus be possible to convert a speaker from being a passive device into an active device by the inclusion of a local power amplifier module. This could be performed by taking a stereo amplifier module from what has previously been a power amp and inserting it into the speaker. The stereo amplifier module could then provide separate drives to the base and tweeter or could be arranged in a "H" bridge arrangement in order to double its power output. A second stereo amplifier module could then be purchased and placed in the other speaker (at least in a two channel system) in order to produce the second active speaker. Each speaker case could also include spaces to accept an active cross over module and, optionally, a data link module providing for the transmission of music data via an infra-red or radio link. Thus the only cabling which need to be provided to the speakers is a power supply.

Preferably the central controller is responsive to a remote control device. Advantageously the remote control includes a display in order to provide functions to be selected on a menu driven basis. Additionally or alternatively, the remote controller is programmable in order to allow extra selections to be added depending on the functionality of the modules within the systems.

Advantageously the case, or more than one case, may be provided with localised controls which attach into an aperture in the front panel (the aperture normally being hidden from view by the removable front panel portion). Advantageously the controls do not form integral parts of the device which they functionally affect, but in fact communicate with the central controller using the same control protocol as may be used by a remote control unit, if provided. Thus, an amplifier may be provided with a front panel which includes volume, bass, treble, balance and source select functions. However, at a later date, the user may wish to change the appearance of the amplifier to a more minimalistic look, where it may only have a volume control or no controls at all (this being because the device can still be controlled via the remote control). Consequently, the user can simply remove the control bearing portion from the front of the panel and replace it by an alternative portion bearing fewer controls, more controls, or no controls at all, or simply having different aesthetic styling. Thus it is possible to change the appearance and number and type of controls on the equipment without requiring the replacement of those modules actually performing the specific tasks.

Preferably the remote control unit is provided with a docking station at which it can dock with the case in order to communicate directly with the central controller and/or be recharged.

Preferably the central controller is programmable such that, as new modules are released, the functionality of the controller may be upgraded to take account of the new features.

Preferably the modules come in a range of standard sizes. Advantageously the modules are substantially integer multiples of a base width. The case may be provided with at least one of a bottom and top plate having regularly arranged located means, such a grooves, formed therein. The modules may be provided with co-operating portions thereby enabling a module to be slotted into the case, whilst being held against movement therein once it has been fixed in position.

Preferably a plurality of case sizes and styles are provided in order to give the options to form separate units, ie cassette decks, amplifier and so or integrated units ie music system, music system and television system and so on. The case may be styled to be aesthetically pleasing, for example to look like a piece of furniture, such as a table or a side board or even a chair and the like.

Preferably the modules are fully enclosed. Thus the technically inexperienced user has no risk of touching or otherwise damaging the components within a module.

According to a second aspect of the present invention, there is provided a rechargeable remote control unit for controlling an electronic system.

The present invention will further be described, by way of example with reference to the accompanying drawings, in which:
Figure 1 is a perspective view of a first case styled to look like a hi-fi separate;
Figure 2 is a perspective view of four modules showing their differing dimensions;
Figure 3 is a perspective view of the rear of the case shown in figure 1 and illustrating two modules in position;
Figure 4 shows the case of Figure 3 with the modules partially removed for clarity;
Figure 5 is a cross section through a module;
Figure 6 is a perspective view of a home entertainment system incorporating a television and stereo unit; and
Figure 7 shows a docking bay where a remote control unit within the system shown in Figure 6.

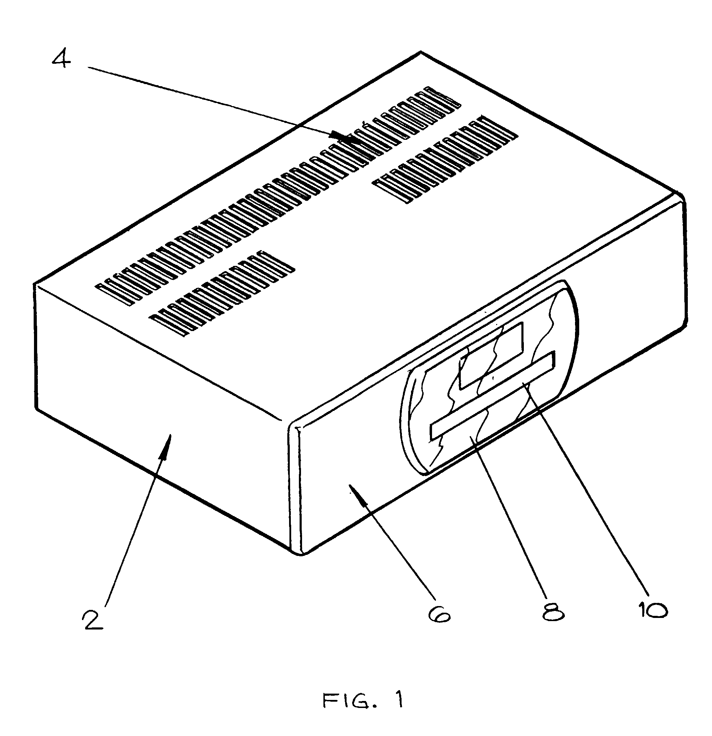

The case shown in Figure 1 comprises a rectangular box 2 having ventilation holes 4 formed in an upper portion thereof. The case is provided with a removable front panel 6 which is held in a clip fit manner to the case. The front panel 6 includes a further removable portion 8. This, depending on application, may include a number of controls in order to allow the units to be operated without using a remote controller, and/or may define the loading apertures for a cassette deck, video recorder or a CD player or other device for recording or playing a removable data medium. The arrangement shown in figure 1 is illustrated with an elongate slot 10 which defines the loading bay for a CD. The case 2 can accept a plurality of modules containing circuit boards defining the functionality of the units. It will be appreciated that different sizes of modules may be required, because they may contain physically large mechanical units such as a cassette transport mechanism, a CD playing unit or a video tape transport mechanism. Furthermore, the size of the modules may also be dictated by their thermal dissipation. Thus, power amplifier modules will tend to be relatively large because of the size of heat sinks contained therein.

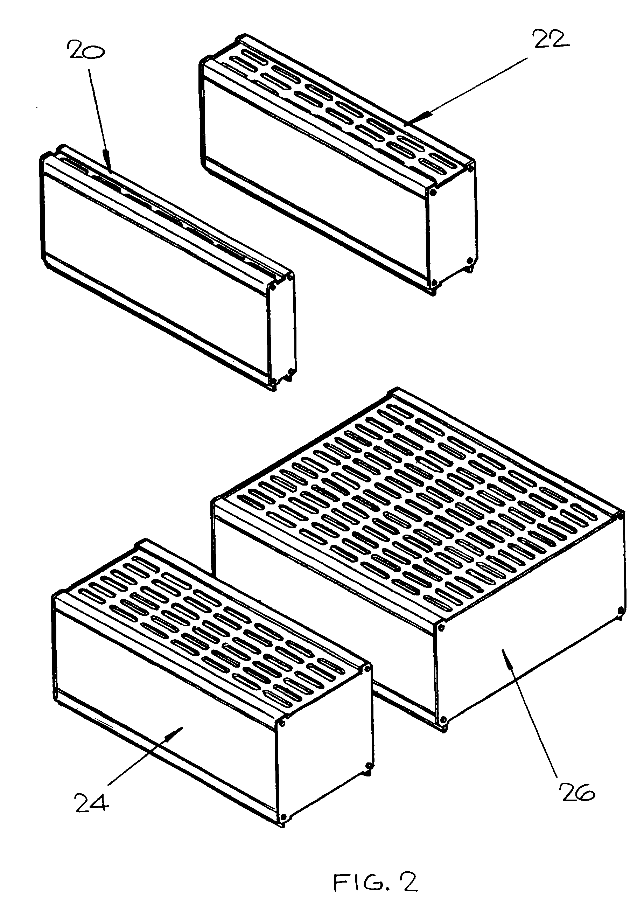

Figure 2 schematically illustrates four modules, 20, 22, 24, and 26. Module 20 is the thinnest module and can be regarded as having unit width. Module 22 is a double width module, module 24 is a treble width module, and module 26 is a quadruple width module. In a specific embodiment of the invention, it is contemplated that these module sizes will be approximately 26mm, 53mm, 107mm and 215mm wide.

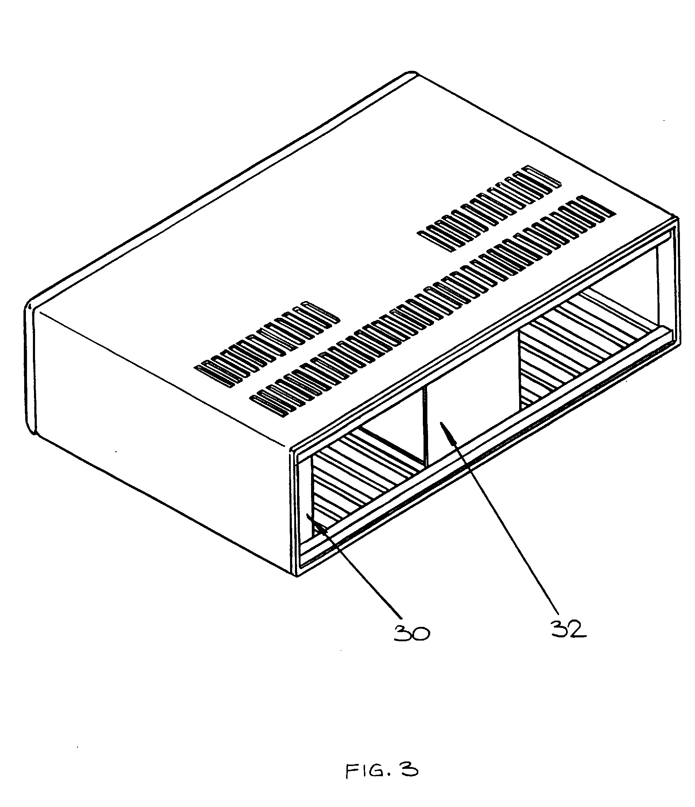

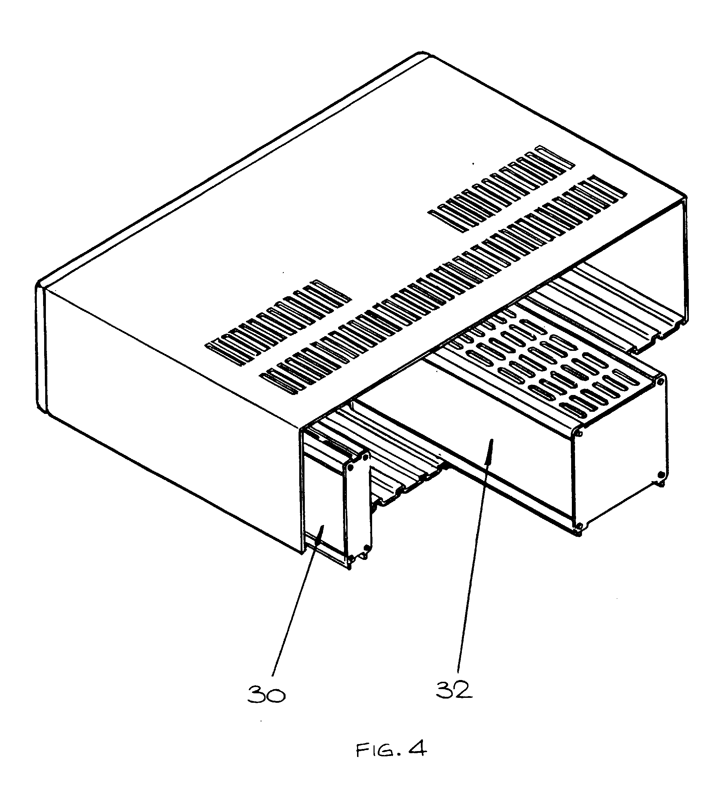

Figure 3 shows a rear view of the unit in Figure 1 with first and second modules 30 and 32 being shown in position. Figure 4 shows the modules in a partially extracted state for greater clarity.

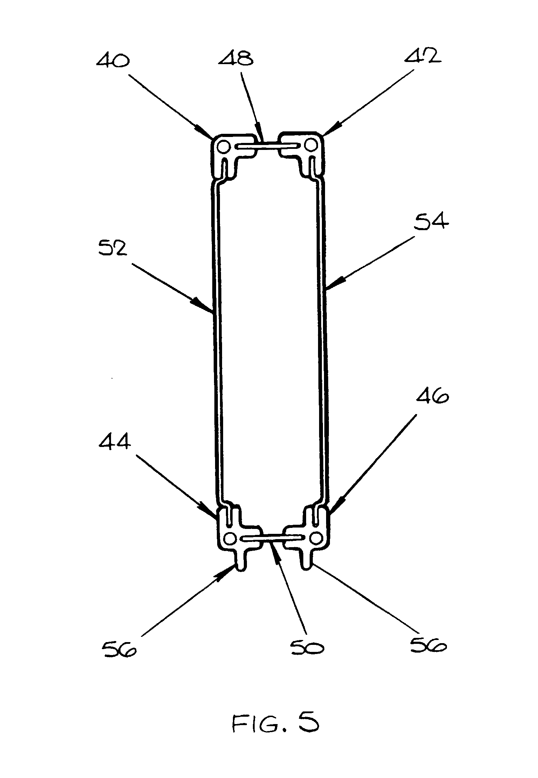

Figure 5 shows a cross section through the case of module 20 of Figure 2. The module has four extruded corner components 40, 42, 44 and 46. Each component can be regarded as generally L shaped with each arm of the L being composed of adjacent fingers which grip sidewalls of the case. The upper and lower walls 48 and 50 are planar, whereas as the lateral side walls 52 and 54 have profiled end portions which bend inwardly to engage with the corner elements. The lower most elements 44 and 46 also include downwardly projecting fingers 56 which, in use, locate in valleys formed in a lower surface of the case in order to hold the modules securely within the case.

As shown in Figure 6, the case can come in a plurality of sizes and styles. One or more cases may be stacked together to form a tower system. A large case 60 may be provided to hold the display portion of a television and/or computer system. This is still conventionally a cathode ray tube, although other display technologies are available and may become more prevalent in the future. Given the high voltages currently used with cathode ray tubes, it is likely that the cathode ray tube and its power supply unit would be provided as a single entity.

The flexibility of the modular approach has the advantage of enabling each and any of the components to be upgraded as technology develops. Additionally and alternatively, it allows the appearance of the system to be changed to suit the current trends or users taste without having to discard the functional units contained therein.

The removable or replaceable controls are held within a self contained control unit which can clip into or otherwise engage with the aperture left in the panel 6 after the portion 8 has been removed. The control unit may or may not have electrical connection with the central controller and/or the modules. The controller may include display devices, for example to indicate the modes selected or the signal levels (eg a VU or peak function when recording or replaying media). Mono or bidirectional data exchange between the central controller and the self contained control unit may be via radio, infra-red or inductive link. An inductive link may also be used to power the control unit.

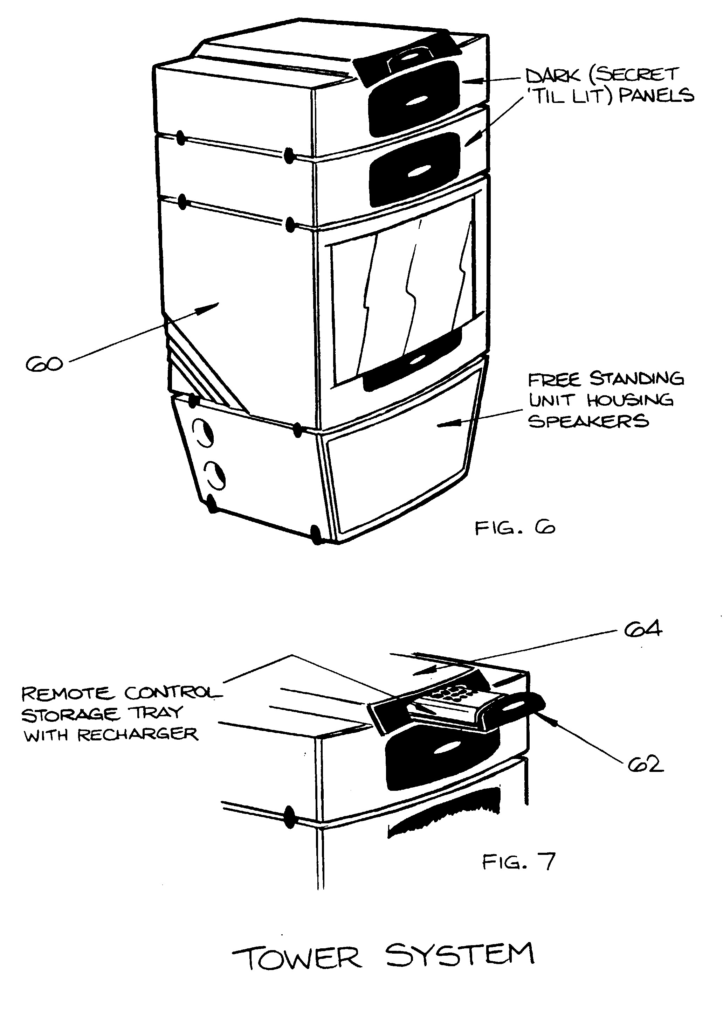

As shown in Figure 7, the remote control unit 62 may be provided with a docking bay 64 to enable it to be stored conveniently and also to be recharged. The remote control may include a display device to display control options, preferably in a menu form, and optionally to provide a help facility.

The modular consumer electronics system makes upgrading a relatively simple and inexpensive procedure since new modules can easily be transferred to a new chassis. As mentioned before, the system is applicable to hi-fi, video recorders, televisions and computers. It also offers an ideal way to successfully integrate these products into a multi-media home entertainment's system. All items continue to operate from the original hand set for maximum simplicity and convenience. The addition of a home computer to the system allows new features to be added at any time. These can include features such as pass word protection and maximum volume control to prevent children from playing the system to loudly. The ability to cope with the inevitable development of new technologies which were unavailable at the time the original system was bought also makes the modular approach "future proof" since it can be upgraded with time, as opposed the current approach which requires the old equipment to be thrown away and a completely new system brought. The fact that individual components can be changed, especially in the event of failure makes the system environmentally sound. Typically, CD players are completely replaced even though the laser (the most common cause of failure) is probably the only component to fail. The modular approach avoids the requirement of disposing of many serviceable items simply to replace a faulty component. The benefit of being able to provide replaceable control panels on each element makes styling changes particularly easy. This enhances the ability of a manufacturer to provide a wide product range whilst actually reducing the number of components that they have to manufacture and stock. In particular, this approach provides a cost effective way for a user to upgrade their own equipment simply and effectively without having to go through the requirements of taking the case off the unit to expose the actual electronics or mechanisms themselves. The features of boxes within boxes greatly reduces the requirement to be technically competent when undertaking such upgrades and also greatly reduces the chance of damaging the equipment when fitting new modules.

It is thus possible to provide a flexible and inexpensive modular home electronics system.

## Claims

1. A case (2) for a modular electronic system characterised in that the case has a front panel (6) having at least one removable portion (8) such that the look or arrangement of controls on the case can be changed, and/or that an aperture for the introduction of removable data carrier into the case is provided.

2. A modular system comprising a case as claimed in claim 1, characterised in that a module (20, 22, 24, 26) may contain components of an audio, video, television and/or computer system.

3. A modular system as claimed in claim 2, characterised in that a plurality of system functions are integrated within a single case.

4. A modular system as claimed in any one of claims 2 or 3, characterised in that the system has a central controller which communicates with all the modules provided within a case (2).

5. A modular system as claimed in any one of claims 2 to 4, characterised in that a single controller communicates with a plurality of modules irrespective of whether they are provided in a single case of a plurality of cases arranged in proximity to one another.

6. A modular system as claimed in claim 4 or 5, characterised in that the central controller is arranged to automatically identify the modules which it is to control.

7. A modular system as claimed in claim 4, 5 or 6, characterised in that the central controller is responsive to a remote control device.

8. A modular system as claimed in any one claims 2 to 7, characterised in that each module carries a plurality of plugs and/or sockets on a predetermined part thereof.

9. A modular system as claimed in claim 8, characterised in that interconnections between modules are provided on a rear face of each module.

10. A modular system as claimed in any one of claims 2 to 9, characterised in that modules are interconnected via a back plane.

11. A modular system as claimed in any one of claims 2 to 10, characterised in that modules communicate with each other via a multiplexed bus.

12. A modular system as claimed in any one of the preceding claims, characterised in that the case houses a transducer element or elements.

13. A modular system as claimed in any one of the preceding claims, characterised in that the case, or more than one case, is provided with a control unit which attaches into an aperture in the front panel.

14. A modular system as claimed in claim 13, characterised in that the control unit sends instructions to the central controller.

15. A modular system as claimed in claim 14, in which the control unit utilises a contactless interface to communicate with the central controller.

16. A modular system as claimed in any one of claim 4 to 7, characterised in that the central controller is programmable such that it can be upgraded to take account of new features.

17. A modular electronic system as claimed in any one of the preceding claims, further comprising a docking station for a remote control unit.

18. A modular electronic system as claimed in any one of the preceding claims, characterised in that the modules come in a range of standard sizes.

19. A modular electronic system as claimed in claim 18, in which housings for the modules are substantially integer multiples of a base width.

20. A modular electronic system as claimed in any one of the preceding claims, in which the case is provided with at least one of a bottom plate and a top plate having regularly arranged locating means for locating the modules.

21. A modular electronic system as claimed in claim 20, in which the locating means are grooves and the modules have co-operating portions enabling them to be slotted into the case.

22. A rechargeable remote control unit for controlling an electronic system.
